# EUROPÄISCHE PATENTSCHRIFT

(11) **EP 0 600 897 B1**
(45) Veröffentlichungstag und Bekanntmachung des Hinweises auf die Patenterteilung: **27.08.1997**
(21) Anmeldenummer: 92913585.3
(22) Anmeldetag: 29.06.1992
(51) Int. Cl.: H01L 29/08, H01L 29/739

(54) **LEISTUNGS-HALBLEITERBAUELEMENT UND VERFAHREN ZU DESSEN HERSTELLUNG**
POWER SEMICONDUCTOR COMPONENT AND PROCESS FOR PRODUCING IT
COMPOSANT SEMI-CONDUCTEUR DE PUISSANCE ET PROCEDE POUR SA FABRICATION

(30) Priorität: 15.07.1991 DE 4123414
(43) Veröffentlichungstag der Anmeldung: 15.06.1994
(73) Patentinhaber: SIEMENS AKTIENGESELLSCHAFT, 80333 München (DE)
(72) Erfinder: OPPERMANN, Klaus-Günter, D-83607 Holzkirchen (DE); STOISIEK, Michael, D-85521 Ottobrunn (DE)
(86) Internationale Anmeldenummer: DE9200536
(87) Internationale Veröffentlichungsnummer: WO9302474

(56) Entgegenhaltungen:
- EP-A- 0 327 901
- DE-A- 3 917 769
- DE-A- 4 014 207
- PATENT ABSTRACTS OF JAPAN vol. 7, no. 58 (E-163)(1203) 10. M rz 1983 & JP-A-57 206 072
- PATENT ABSTRACTS OF JAPAN vol. 14, no. 292 (E-944)(4235) 25. Juni 1990 & JP-A-20 94 570
- PATENT ABSTRACTS OF JAPAN vol. 13, no. 301 (E-785)(3649) 11. Juli 1989 & JP-A-10 80 077

## Beschreibung

Die vorliegende Erfindung betrifft ein Leistungs-Halbleiterbauelement nach dem Oberbegriff des Patentanspruchs 1 und ein Verfahren zu dessen Herstellung nach dem Oberbegriff des Patentanspruchs 8.

Ein Leistungs-Halbleiterbauelement der gattungsgemäßen Art ist beispielsweise aus dem Buch W. Gerlach, "Thyristoren", Reihe Halbleiterelektronik Band 12, Springer-Verlag Berlin/Heidelberg/New York, 1979, Seiten 56, 57, 140 und 141 bekannt. Dabei handelt es sich um Thyristoren mit einer Emitterzone die Aussparungen für Emitterkurzschlüsse aufweist. Durch die Emitterkurzschlüsse wird die Vorwärtssperrfähigkeit verbessert, da der Emitterwirkungsgrad für sehr kleine Lastströme annähernd Null ist.

Aus den Patent Abstracts of Japan, Vol. 7, November 58 (E-163) [1203], March 10, 1983, ist ein Halbleiterbauelement bekannt, das Emitterkurzschlüsse zur Begrenzung des Laststromanstiegs im Störfall aufweist.

Aus den Patent Abstracts of Japan, Vol. 13, Number 301 (E-785) [3649], July 11, 1989, ist ein leitfähigkeitsmodulierter MOSFET bekannt, bei dem ganzflächig eine p-dotierte Schicht zwischen einer n-dotierten Basisschicht und einer Schicht aus abwechselnd n⁺- und p⁺-doterten Bereichen vorgesehen ist, um die Latch-up-Neigung und den Durchlaßwiderstand zu senken.

Der Erfindung liegt nun die Aufgabe zugrunde, ein Leistungs-Halbleiterbauelement in Form eines Bipolartransistors mit isoliertem Gate (IGBT) anzugeben, dessen Emitterwirkungsgrad bei relativ hohen Lastströmen annähernd zu Null wird und bei dem ein Zünden eines parasitären Thyristors (Latch-up) vermieden wird. Diese Aufgabe wird erfindungsgemäß durch die im kennzeichnenden Teil des Patentanspruchs 1 angegebenen Merkmale gelöst.

Die Ansprüche 2 bis 7 sind auf bevorzugte Ausbildungen des erfindungsgemäßen Leistungs-Halbleiterbauelementes gerichtet.

Der Anspruch 9 betrifft eine bevorzugte Ausbildung des erfindungsgemäßen Herstellverfahrens.

Die Erfindung wird nachfolgend anhand der Zeichnung näher erläutert. Dabei zeigt
- Figur 1: einen Schnitt durch einen Teilbereich eines Leistungs-Halbleiterbauelementes nach der Erfindung,
- Figur 2: einen Schnitt durch ein Ausführungsbeispiel der Erfindung,
- Figur 3: einen Schnitt durch einen GTO,
- Figur 4: ein Strom/Spannungsdiagramm eines Leistungs-Halbleiterbauelementes nach Figur 3 und
- Figur 5a bis 5e: Schnittdarstellungen zur Verdeutlichung einzelner Schritte eines erfindungsgemäßen Verfahrens zur Herstellung eines Leistungs-Halbleiterbauelementes nach der Erfindung.

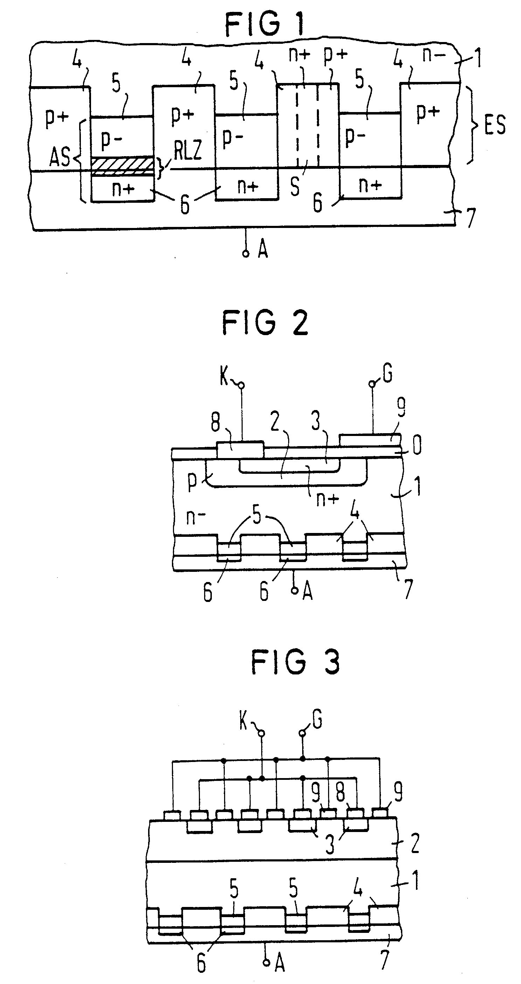

In Figur 1 ist eine Ausschnittsdarstellung eines erfindungsgemäßen Leistungs-Halbleiterbauelementes, bei der sich an eine n⁻-dotierte Mittelzone 1 anodenseitig eine Emitterzone EZ anschließt, die aus p⁺-dotierten Emittergebieten 4 und p⁻-dotierten ersten Teilen 5 von Absaugstrukturen besteht. An den ersten Teil 5 einer Absaugstruktur AS schließt sich jeweils ein n⁺-dotierter zweiter Teil 6 der Absaugstruktur AS an und ist elektrisch leitend mit einer Anodenelektrode 7 verbunden, die ihrerseits einen Anodenanschluß A aufweist und elektrisch leitend mit den Emittergebieten 4 verbunden ist. Dabei können die Emittergebiete 4 n⁺-dotierte Emitterkurzschlußgebiete S aufweisen, die, wie dies in der Figur 1 gestrichelt angedeutet ist, die Mittelzone mit der Anodenelektrode A verbinden. Ferner ist beispielhaft bei der Absaugstruktur AS im Bereich eines Übergangs zwischen dem ersten und zweiten Teil der Absaugstruktur AS eine Raumladungszone RLZ schraffiert eingetragen.

Im Durchlaßzustand des erfindungsgemäßen Leistungs-Halbleiterbauelementes befindet sich in der Mittelzone 1, vor der Emitterzone EZ eine Speicherladung aus freien Elektronen und Löchern. Die vor den Emittergebieten 4 befindlichen Elektronen führen in der üblichen Weise zur Injektion von Löchern in die Mittelzone 1. Das Verhalten der vor den ersten Teilen 5 der Absaugstruktur AS befindlichen Elektronen ist stark von der dort auftretenden Elektronen-Dichte abhängig. Bei einer geringen Elektronen-Dichte, also bei geringen Lastströmen, diffundieren die Elektronen in die ersten Teile 5 der Absaugstruktur AS, kommen aber nicht bis zur Raumladungszone RLZ, da sie vorher rekombinieren. Die für die Rekombination erforderlichen Löcher werden über die p⁺-dotierten Emittergebiete 4 aus der Anodenelektrode 7 nachgeliefert. Bei einer hohen Elektronen-Dichte hingegen erreichen die Elektronen die Raumladungszone RLZ und ein daraus resultierendes elektrisches Feld, das die Elektronen in Richtung Anodenelektrode 7 absaugt. Es werden ständig Elektronen aus der Mittelzone 1 abgesaugt, wodurch weniger Elektronen eine Injektion von Löchern aus den Emittergebieten 4 verursachen und aufgrund dessen die anodenseitige Emittereffizienz abnimmt. Die Absaugstrukturen AS wirken wie Emitterkurzschlüsse, die sich beim Überschreiten einer kritischen Stromstärke schlagartig zuschalten. Eine kritische Elektronen-Dichte von der ab dies geschieht, wird im wesentlichen von der Dicke und der Dotierungskonzentration der ersten Teile 5 der Absaugstrukturen bestimmt. Die Elektronen-Dichte hängt dabei von der Höhe des Laststromes und den Lateralabmessungen der Emittergebiete 4 und der Absaugstrukturen ab. Mit Hilfe der oben genannten Parameter läßt sich die kritische Stromstärke, bei der eine Absaugwirkung einsetzt, gezielt einstellen.

Figur 2 zeigt ein erstes Ausführungsbeispiel eines erfindungsgemäßen Leistungs-Halbleiterbauelementes in Form eines Bipolartransistors mit isolierter Basis (IGBT), der die bei Figur 1 bereits näher ausgeführte Mittelzone 1 die anodenseitigen Emittergebiete 4, die ersten Teile 5 der Absaugstrukturen AS, die zweiten Teile 6 der Absaugstrukturen AS, die Anodenelektrode 7 und den Anodenanschluß A aufweist. Darüber hinaus ist kathodenseitig eine p-dotierte Basiszone 2 wannenförmig in den IGBT eingebracht und beinhaltet ein n⁺-dotiertes kathodenseitiges Emittergebiet 3. Eine mit einem Gateanschluß G versehene Gateelektrode 9 ist durch eine Oxidschicht 0 vom Halbleiterkörper getrennt, wobei die Gateelektrode 9 die Basiszone dort überdeckt, wo sie an die Oberfläche des Halbleiterkörpers tritt. Auf der von der Gateelektrode abgewandten Seite der Zonen 2 und 3 ist eine Kathodenelektrode 9 angeordnet, die einen starken Nebenschluß zwischen den Zonen 2 und 3 bildet und mit einem Kathodenanschluß K kontaktiert ist.

Der in Figur 2 gezeigte IGBT besitzt einen parasitären Thyristor der aus den Emitterbereichen 4 und den Zonen 1, 2 und 3 besteht. Ist die Emittereffizienz der anodenseitigen Emitterzone EZ und die Ladungsträgerdichte hoch, kann dies zum Zünden des parasitären Thyristors (latch up) führen.

Durch die Erfindung wird bei hohen Ladungsträgerdichten die Emittereffizienz reduziert und somit ein unerwünschtes Zünden des parasitären Thyristors wirksam vermieden. Dabei ist die Schwelle hierfür so zu legen, daß dies geschieht, bevor eine zur Zündung ausreichende Verstärkung des aus den Zonen 1, 2 und 3 gebildeten Bipolartransistors erreicht wird.

In Figur 3 ist ein Beispiel in Form eines Abschaltthyristors dargestellt, der auch als GTO bekannt ist. Er besitzt wiederum eine n⁻-dotierte Mittelzone 1, eine kathodenseitige Basiszone 2, in die kathodenseitig Emitterzonen 3 eingebettet sind. Ferner besitzt er ebenfalls, die bei Figur 1 und 2 beschriebene Anordnung aus Absaugstruktur AS und anodenseitigen Emittergebieten 4. Die Emitterzonen 3 sind mit Emitterelektroden 8 versehen, zwischen denen Gateelektroden 9 angeordnet sind. Die Gateelektroden 9 sind alle mit einem Gateanschluß G und die Emitterelektroden 8 sind alle mit einem Kathodenanschluß K verbunden und damit jeweils parallel geschaltet.

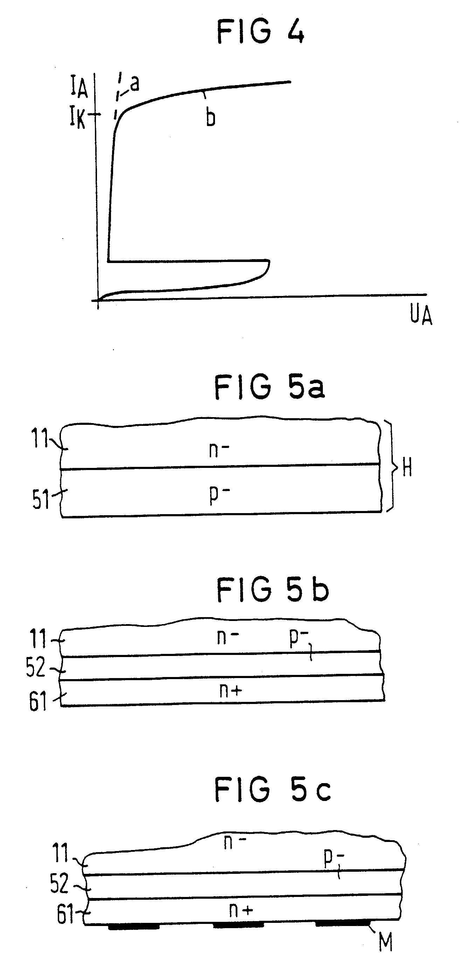

Bei GTOs und Thyristoren bewirkt die Anordnung aus den Absaugstrukturen AS und den Emittergebieten 4 eine pentodenartige Ausgangskennlinie. Zum Vergleich ist in Figur 4 eine Ausgangskennlinie b eines GTOs nach Figur 3 und eine Ausgangskennlinie a eines konventionellen GTOs in einem Strom-Spannungsdiagramm dargestellt, wobei ein Anodenstrom I_{A} über einer Anodenspannung U_{A} aufgetragen ist und die Kennlinien a und b bis zu einem kritischen Anodenstrom I_{K} identisch sind. Steigt der Anodenstrom I_{A} über den kritischen Anodenstrom I_{K}, so nimmt beispielsweise der GTO stark Spannung auf und der Spannungsabfall am GTO kann beispielsweise als Eingangsgröße für eine Abschalteinrichtung dienen.

Ein vorteilhaftes Verfahren zur Herstellung eines Leistungs-Halbleiterbauelementes nach der Erfindung ist in den Figuren 5a bis 5e verdeutlicht, wobei jeweils ein anodenseitiger Bereich eines Halbleiterkörpers H jeweils nach einem wesentlichen Verfahrensschritt dargestellt ist. Hierbei zeigt Figur 5a den anodennahen Bereich des Halbleiterkörpers nach einem ersten Verfahrensschritt, bei dem in einem n⁻-dotierten, also schwach n-dotierten, Halbleiterkörper H eine dicke p⁻-dotierte, also schwach p-dotierte, Schicht 51 ganzflächig implantiert wird, wobei ein n⁻-dotierter Bereich 11 für die spätere Mittelzone 1 verbleibt. Die ganzflächige Implantation erfolgt beispielsweise mit einer Dosis von 10¹⁴ Bor-Atomen/cm².

In Figur 5b ist der Bereich des Halbleiterkörpers nach einem zweiten Verfahrensschritt dargestellt, bei dem ganzflächig in die Dicke p⁻-dotierte Schicht 51 eine n⁺-dotierte, also stark n-dotierte, Schicht 61 für die späteren zweiten Teile 6 der Absaugstrukturen implantiert wird, so daß zwischen der Schicht 61 und der Schicht 11 eine dünne p⁻-dotierte Schicht 52 bestehen bleibt. Die n⁺-Implantation erfolgt mit einem langsam diffundierenden Donator, zum Beispiel Arsen oder Antimon, wobei die Dosis, beispielsweise 10¹⁶ cm⁻², so zu wählen ist, daß die Dotierungskonzentration nach Abschluß des zweiten Verfahrensschrittes ca. 10²⁰ cm⁻³ beträgt. In Figur 5c ist der Bereich des Halbleiterkörpers nach einem dritten Verfahrensschritt gezeigt, bei dem eine Abdeckung von Bereichen für die späteren Absaugstrukturen mit einer Lack- oder Oxidmaske M erfolgt.

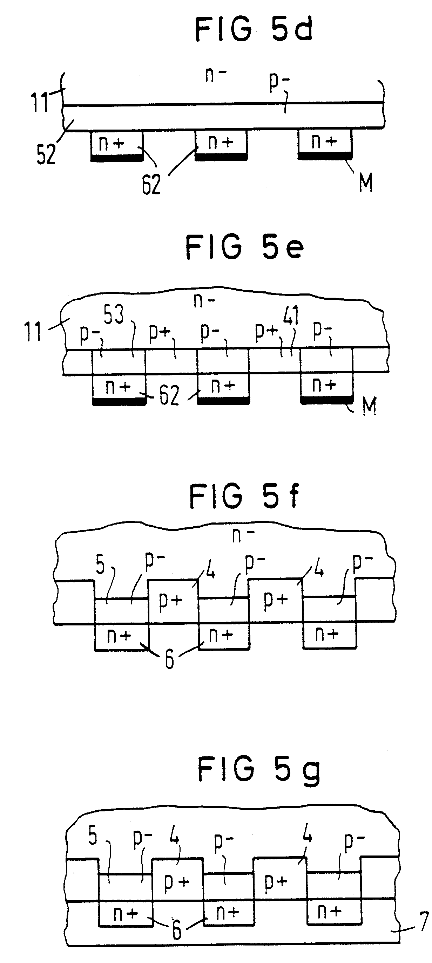

In Figur 5d ist der Bereich des Halbleiterkörpers H nach einem vierten Verfahrensschritt ersichtlich, bei dem die n⁺-dotierte Schicht 61 im Bereich der späteren Emittergebiete 4 bis zur p⁻-dotierten Schicht 52 abgeätzt wird und bei dem aus der Schicht 61 Bereiche 62 für die späteren zweiten Teile 6 der Absaugstrukturen werden.

Figur 5e zeigt den Bereich des Halbleiterkörpers H nach einer p⁺-Belegung, also einer starken p-Dotierung, bei der in einem fünften Verfahrensschritt in der Schicht 52, in durch die Maske M nicht abgedeckten Stellen, p⁺-dotierte Bereiche 41 für die späteren anodenseitigen Emittergebiete 4 erzeugt werden und an durch die Maske M abgedeckten Stellen p⁻-dotierte Bereiche 53 für die späteren ersten Teile 5 der Absaugstrukturen gebildet werden. Von besonderem Vorteil ist hierbei, daß die Maske M sowohl für den Ätzschritt als auch für die p⁺-Belegung verwendbar ist.

Nach dem Entfernen der Maske M werden durch einen sechsten Verfahrensschritt in Form eines Eintreibeschrittes, bei dem durch Ätzen des Halbleiterkörpers vor allem die p⁺-dotierten Bereiche 41 in den Halbleiterkörper eingetrieben werden, wodurch, wie aus Figur 5f ersichtlich, die Emittergebiete 4 sich tiefer in den Halbleiterkörper ausdehnen als die ersten Teile 5 der Absaugstrukturen. Als siebter und letzter Verfahrensschritt erfolgt von der anodenseitigen Uberfläche aus eine Metallisierung, bei der eine Anodenelektrode 7 gebildet wird, die, wie aus Figur 5g entnehmbar, eine Berührungsfläche zu den zweiten Teilen 6 der Absaugstrukturen und zu den Emittergebieten 4 besitzt.

Die bisher getroffenen Aussagen beziehen sich der Einfachheit halber nur auf ein erfindungsgemäßes Leistungs-Halbleiterbauelement, dessen Mittelzone 1, also das Ausgangsmaterial, n⁻-dotiert ist. Die Erfindung betrifft jedoch in gleichem Maße Leistungs-Halbleiterbauelemente mit einer p⁻-dotierten Mittelzone, wobei hier nur alle Zonen bzw. Gebiete in ihrem Leitfähigkeitstyp und die Anoden mit den Kathoden zu vertauschen sind. Für ein Verfahren zur Herstellung eines erfindungsgemäßen Leistungs-Halbleiterbauelementes mit p⁻-dotierter Mittelzone sind jeweils Akzeptoren anstelle von Donatoren und umgekehrt zu verwenden.

## Patentansprüche

1. Leistungshalbleiterbauelement in Form eines Bipolartransistors mit isoliertern Gate (IGBT) mit einer ersten Hauptelektrode (8), die elektrisch leitend mit mindestens einer ersten Emitterzone (3) eines ersten Leitfähigkeitstyps und mindestens einer Basiszone (2) eines zweiten Leitfähigkeitstyps verbunden ist,
mit einer Gateelektrode (9), die durch eine Oxidschicht vom Halbleiterkörper getrennt die Basiszone (2) dort überdeckt, wo diese an die Oberfläche des Halbleiterkörpers tritt,
mit einer Mittelzone (1) des ersten Leitfähigkeitstyps und
mit einer zweiten Hauptelektrode (7), die sowohl über mindestens ein stark dotiertes Emittergebiet (4) des zweiten Leitfähigkeitstyps als auch über eine aus zwei Teilen bestehende Absaugstruktur (AS) direkt mit der Mittelzone (1) verbunden ist, wobei der mit der zweiten Hauptelektrode verbundene Teil (6) der Absaugstruktur einen ersten Leitfähigkeitstyp und eine im Vergleich zur Mittelzone hohe Dotierungskonzentration und der mit der Mittelzone verbundene Teil (5) der Absaugstruktur einen zweiten Leitfähigkeitstyp und eine im Vergleich zur Basiszone (2) des zweiten Leitfähigkeitstyps niedrige Dotierungskonzentration aufweist.

2. Leistungs-Halbleiterbauelement nach Anspruch 1, **dadurch gekennzeichnet,** daß mindestens ein Emitterkurzschlußgebiet (S) in Form eines stark dotierten Verbindungsgebietes des ersten Leitfähigkeitstyps (n) zwischen der Mittelzone (1) und der zweiten Hauptelektrode (7) eingebracht ist.

3. Leistungs-Halbleiterbauelement nach Anspruch 1 oder 2,
**dadurch gekennzeichnet,**
daß die kritische Stromstärke (I_{K}) durch die Dicke und/oder die Dotierungskonzentration des ersten Teiles (5) der Absaugstruktur (AS) und/oder durch die Lateralabmessung von Absaugstrukturen und Emittergebieten gezielt vorgebbar ist.

4. Leistungs-Halbleiterbauelement nach Anspruch 1 oder 2,
**dadurch gekennzeichnet,** daß der erste Teil (5) der Absaugstruktur (AS) als zusammenhängendes Gebiet ausgeführt ist, in dem mindestens ein stark dotiertes Emittergebiet des zweiten Leitfähigkeitstyps inselförmig ausgespart ist.

5. Leistungs-Halbleiterbauelement nach Anspruch 1 oder 2,
**dadurch gekennzeichnet,** daß das stark dotierte Emittergebiet (4) des zweiten Leitfähigkeitstyps (p) als zusammenhängendes Gebiet ausgeführt ist, in dem mindestens ein erster Teil (5) einer Absaugstruktur (AS) inselförmig ausgespart ist.

6. Leistung-Halbleiterbauelement nach Anspruch 1 oder 2,
**dadurch gekennzeichnet,** daß die Mittelzone n-leitend ist.

7. Leistungs-Halbleiterbauelement nach Anspruch 1 oder 2,
**dadurch gekennzeichnet,** daß die Mittelzone p-leitend ist.

8. Verfahren zur Herstellung eines Leistungs-Halbleiterbauelementes mit mindestens einer ersten Emitterzone (3) eines ersten Leitfähigkeitstyps (n), die mit einer ersten Hauptelektrode (8) elektrisch leitend verbunden ist, mit mindestens einer Basiszone (2) eines zweiten Leitfähigkeitstyps (p), mit einer Mittelzone (1), mit einer zweiten Emitterzone (EZ), die aus mindestens einem stark dotierten Emittergebiet (4) eines zweiten Leitfähigkeitstyps (p) und mindestens einem dazu unterschiedlich aufgebauten weiteren Gebiet der Emitterzone (EZ) besteht, und mit einer zweiten Hauptelektrode (7), die mit dem stark dotierten Emittergebiet (4) des zweiten Leitfähigkeitstyps (p) direkt elektrisch leitend verbunden ist, bei dem das weitere Gebiet der zweiten Emitterzone (EZ) schwach dotiert ist, den zweiten Leitfähigkeitstyp (p) besitzt und einen ersten Teil (5) einer Absaugstrauktur (AS) bildet und bei dem ein zweiter Teil (6) der Absaugstruktur (AS) stark dotiert ist, den ersten Leitfähigkeitstyp (n) aufweist und den ersten Teil (5) der Absaugstruktur (AS) mit der zweiten Hauptelektrode (7) verbindet,
**dadurch gekennzeichnet,** daß in einem Halbleiterkörper (H) des ersten Leitungstyps (n) ganzflächig eine dicke schwach dotierte Schicht (51) des zweiten Leitfähigkeitstyps (p) implantiert wird, daß in die dicke schwach dotierte Schicht (51) des zweiten Leitfähigkeitstyps (p) ganzflächig eine stark dotierte Schicht (61) des ersten Leitfähigkeitstyps (n) mit Hilfe eines langsam diffundierenden Dotierungsstoffes (Donator) implantiert wird, wobei eine dünne schwach dotierte Schicht (52) des zweiten Leitfähigkeitstyps (p) erhalten bleibt, daß die stark dotierte Schicht (61) des ersten Leitfähigkeitstyps (n) mit Hilfe einer Maske (M) mindestens in einem Bereich abgedeckt wird, daß mindestens ein nicht durch die Maske (M) abgedeckter Bereich der stark dotierten Schicht (61) des ersten Leitfähigkeitstyps (n) weggeätzt wird und mindestens ein stark dotiertes Gebiet (62) des ersten Leitfähigkeitstyps (n) bestehen bleibt, daß mindestens ein nicht durch die Maske (m) abgedeckter Bereich der dünnen, schwach dotierten Schicht (52) des zweiten Leitfähigkeitstyps (p) stärker dotiert wird als ein durch die Maske (M) abgedeckter Bereich und mindestens ein schwach dotiertes Gebiet (53) des zweiten Leitfähigkeitstyps (p) und mindestens ein stark dotiertes Gebiet (41) des zweiten Leitfähigkeitstyps (p) gebildet werden, daß mindestens ein schwach dotiertes Gebiet (53) des zweiten Leitfähigkeitstyps (p) und mindestens ein stark dotiertes Gebiet (41) des zweiten Leitfähigkeitstps (p) nach vorherigem Entfernen der Maske (M) durch Erhitzen in den Halbleiterkörper (A) eingetrieben werden, wobei aus den schwach dotierten Gebieten (53) des zweiten Leitfähigkeitstyps (p) erste Teile (5) von Absaugstrukturen, aus stark dotierten Gebieten (41) des zweiten Leitfähigkeitstyps (p) Emittergebiete (4) des zweiten Leitfähigkeitstyps (p) und aus den stark dotierten Gebieten (62) des ersten Leitfähigkeitstyps (n) zweite Teile von Absaugstrukturen (6) gebildet werden und daß eine Metallschicht als zweite Hauptelektrode (7) vorgesehen wird, die elektrisch leitend mit mindestens einem Emittergebiet (4) des zweiten Leitfähigkeitstyps (p) und mindestens einem zweiten Teil (6) einer Absaugstruktur verbunden ist.

9. Verfahren zur Herstellung eines Leistungs-Halbleiterbauelementes nach Anspruch 1, **dadurch gekennzeichnet,** daß die dicke schwach dotierte Schicht (51) des zweiten Leitfähigkeitstyps p-leitend ist und daß die stark dotierte Schicht (61) des ersten Leitfähigkeitstyps (n) mit Hilfe von Arsen oder Antimon als Dotierungsstoff erzeugt wird.

## Claims

1. Power semiconductor component in the form of a bipolar transistor with an insulated-gate (IG-BT), having a first main electrode (8) which is connected in an electrically conducting manner to at least one first emitter zone (3) of a first conductivity type and to at least one base zone (2) of a second conductivity type, having a gate electrode (9) which is isolated from the semiconductor body by an oxide layer and covers the base zone (2) at the point where it emerges at the surface of the semiconductor body, having a centre zone (1) of the first conductivity type and
having a second main electrode (7) which is connected directly to the centre zone (1) both via at least one heavily doped emitter region (4) of the second conductivity type and also via an extraction structure (AS) composed of two parts, that part (6) of the extraction structure which is connected to the second main electrode having a first conductivity type and a high dopant concentration in comparison with the centre zone, and that part (5) of the extraction structure which is connected to the centre zone having a second conductivity type and a low dopant concentration in comparison with the base zone (2) of the second conductivity type.

2. Power semiconductor component according to Claim 1, characterized in that at least one emitter short-circuit region (S) is introduced in the firm of a heavily doped connecting region of the frist conductivity type (n) between the centre zone (1) and the second main electrode (7).

3. Power semiconductor component according to Claim 1 or 2, characterized in that the critical current level (I_{K}) can be predetermined by the thickness and/or the dopant concentration of the first part (5) of the extraction structure (AS) and/or by the lateral dimension of the extraction structures and emitter regions.

4. Power semiconductor component according to Claim 1 or 2, characterized in that the first part (5) of the extraction structure (AS) is constructed as a continuous region in which at least one heavily doped emitter region of the second conductivity type is formed into island-like recesses.

5. Power semiconductor component according to Claim 1 or 2, characterized in that the heavily doped emitter region (4) of the second conductivity type (p) is constructed as a continuous region in which at least one first part (5) of an extraction structure (AS) is formed into island-like recesses.

6. Power semiconductor component according to Claim 1 or 2, characterized in that the centre zone is n-type.

7. Power semiconductor component according to Claim 1 or 2 characterized in that the centre zone is p-type.

8. Process for producing a power semiconductor component having at least one first emitter zone (3) of a first conductivity type (n) which is connected in an electrically conducting manner to a first main electrode (8), having at least one base zone (2) of a second conductivity type (p), having a centre zone (1), having a second emitter zone (EZ) comprising at least one heavily doped emitter region (4) of a second conductivity type (p) and at least one further region of the emitter zone (EZ), which further region is of different construction to the first, and having a second main electrode (7) which is directly connected in an electrically conducting manner to the heavily doped emitter region (4) of the second conductivity type (p), in which power semiconductor component the further region of the second emitter zone (EZ) is lightly doped, is of the second conductivity type (p) and forms a first part (5) of an extraction structure (AS) and in which power semiconductor component a second part (6) of the extraction structure (AS) is heavily doped, is of the first conductivity type (n) and connects the first part (5) of the extraction structure (AS) to the second main electrode (7), characterized in that a thick, lightly doped layer (51) of the second conductivity type (p) is implanted over the entire surface in a semiconductor body (H) of the first conduction type (n), in that a heavily doped layer (61) of the first conductivity type (n) is implanted over the entire surface in the thick, lightly doped layer (51) of the second conductivity type (p) with the aid of a slowly diffusing dopant (donor), a thin, lightly doped layer (52) of the second conductivity type (p) being left, in that the heavily doped layer (61) of the first conductivity type (n) is masked at least in one region with the aid of a mask (M), in that at least one region, not masked by the mask (M), of the heavily doped layer (61) of the first conductivity type (n) is etched away and at least one heavily doped region (62) of the first conductivity type (n) is left, in that at least one region, not covered by the mask (M), of the thin, lightly doped layer (52) of the second conductivity type (p) is more heavily doped than a region masked by the mask (M) and at least one weakly doped region (53) of the second conductivity type (p) and at least one heavily doped region (41) of the second conductivity type (p) are formed, in that at least one lightly doped region (53) of the second conductivity type (p) and at least one heavily doped region (41) of the second conductivity type (p) are driven into the semiconductor body (A) by heating after removing the mask (M) beforehand, first parts (5) of extraction structures being formed by the lightly doped regions (53) of the second conductivity type (p), emitter regions (4) of the second conductivity type (p) being formed from heavily doped regions (41) of the second conductivity type (p) and second parts of extraction structures (6) being formed from the heavily doped regions (62) of the first conductivity type (n), and in that a metal layer is provided as second main electrode (7) which is connected in an electrically conducting manner to at least one emitter region (4) of the second conductivity type (p) and to at least one second part (6) of an extraction structure.

9. Process for producing a power semiconductor component according to Claim 1, characterized in that the thick, lightly doped layer (51) of the second conductivity type is p-type and in that the heavily doped layer (61) of the first conductivity type (n) is produced with the aid of arsenic or antimony as dopant.

## Revendications

1. Composant semi-conducteur de puissance en forme de transistor bipolaire à grille isolée (IGBT) comportant : une première électrode principale (8), qui est raccordée de façon conductrice électriquement à au moins une première zone émettrice (3) d'un premier type de conductibilité et à au moins une zone de base (2) d'un deuxième type de conductibilité,
une électrode de grille (9) qui, séparée du corps semi-conducteur par une couche d'oxyde, recouvre la zone de base (2) là où celle-ci aboutit à la surface du corps semi-conducteur,
une zone centrale (1) du premier type de conductibilité et
une deuxième électrode principale (7) qui est raccordée directement à la zone centrale (1) non seulement au moyen d'au moins une région émettrice fortement dopée (4) du deuxième type de conductibilité mais aussi au moyen d'une structure d'aspiration (AS) composée de deux parties, la partie (6), raccordée à la deuxième électrode principale, de la structure d'aspiration présentant un premier type de conductibilité et une concentration de dopage élevée par comparaison à la zone centrale et la partie (5), raccordée à la zone centrale, de la structure d'aspiration présentant un deuxième type de conductibilité et une concentration de dopage faible par comparaison à la zone de base (2) du deuxième type de conductibilité.

2. Composant semi-conducteur de puissance selon la revendication 1, caractérisé en ce qu'au moins une région à court-circuit d'émetteurs (S) en forme de région de raccord fortement dopée du premier type de conductibilité (n) est mise en place entre la zone centrale (1) et la deuxième électrode principale (7).

3. Composant semi-conducteur de puissance selon la revendication 1 ou 2, caractérisé en ce que l'intensité de courant critique (I_{K}) peut être déterminée de façon adéquate par l'épaisseur et / ou la concentration de dopage de la première partie (5) de la structure d'aspiration (AS) et / ou par la dimension latérale des structures d'aspiration et des régions émettrices.

4. Composant semi-conducteur de puissance selon la revendication 1 ou 2, caractérisé en ce que la première partie (5) de la structure d'aspiration (AS) est réalisée en tant que région continue, dans laquelle au moins une région émettrice fortement dopée du deuxième type de conductibilité est évidée en forme d'île.

5. Composant semi-conducteur de puissance selon la revendication 1 ou 2, caractérisé en ce que la région émettrice fortement dopée (4) du deuxième type de conductibilité (p) est réalisée en tant que région continue, dans laquelle au moins une première partie (5) d'une structure d'aspiration (AS) est évidée en forme d'île.

6. Composant semi-conducteur selon la revendication 1 ou 2, caractérisé en ce que la zone centrale est conductrice du type N.

7. Composant semi-conducteur selon la revendication 1 ou 2, caractérisé en ce que la zone centrale est conductrice du type P.

8. Procédé de fabrication d'un composant semi-conducteur de puissance comportant au moins une première zone émettrice (3) d'un premier type de conductibilité (n), qui est raccordée de façon conductrice électriquement à une première électrode principale (8), avec au moins une zone de base (2) d'un deuxième type de conductibilité (p), avec une zone centrale (1), avec une deuxième zone émettrice (EZ), qui est composée d'au moins une région émettrice fortement dopée (4) d'un deuxième type de conductibilité (p) et d'au moins une autre région, de structure différente, de la zone émettrice (EZ), et avec une deuxième électrode principale (7), qui est raccordée de façon conductrice électriquement directement à la région émettrice fortement dopée (4) du deuxième type de conductibilité (p), dans lequel l'autre région de la deuxième zone émettrice (EZ) est faiblement dopée, possède le deuxième type de conductibilité (p) et forme une première partie (5) d'une structure d'aspiration (AS) et dans lequel une deuxième partie (6) de la structure d'aspiration (AS) est fortement dopée, présente le premier type de conductibilité (n) et raccorde la première partie (5) de la structure d'aspiration (AS) à la deuxième électrode principale (7), caractérisé en ce que dans un corps semi-conducteur (H) du premier type de conductivité (n) est implantée sur toute la surface une épaisse couche faiblement dopée (51) du deuxième type de conductibilité (p), en ce que dans l'épaisse couche faiblement dopée (51) du deuxième type de conductibilité (p) est implantée sur toute la surface une couche fortement dopée (61) du premier type de conductibilité (n) à l'aide d'un agent de dopage se diffusant lentement (donneur), une mince couche faiblement dopée (52) du deuxième type de conductibilité (p) restant maintenue, en ce que la couche fortement dopée (61) du premier type de conductibilité (n) est recouverte à l'aide d'un masque (M) au moins dans une zone, en ce qu'au moins une zone, non recouverte par le masque (M), de la couche fortement dopée (61) du premier type de conductibilité (n) est enlevée par décapage et au moins une région fortement dopée (62) du premier type de conductibilité (n) demeure, en ce qu'au moins une zone non recouverte par le masque (M) de la mince couche faiblement dopée (52) du deuxième type de conductibilité (p) est plus fortement dopée qu'une zone recouverte par le masque (M) et au moins une région faiblement dopée (53) du deuxième type de conductibilité (p) et au moins une région fortement dopée (41) du deuxième type de conductibilité (p) sont formées, en ce qu'au moins une région faiblement dopée (53) du deuxième type de conductibilité (p) et au moins une région fortement dopée (41) du deuxième type de conductibilité (p) sont enfoncées par échauffement dans le corps semi-conducteur (A) après enlèvement préalable du masque (M), les premières parties (5) des structures d'aspiration étant formées à partir des régions faiblement dopées (53) du deuxième type de conductibilité (p), des régions émettrices (4) du deuxième type de conductibilité (p) étant formées à partir des régions fortement dopées (41) du deuxième type de conductibilité (p) et les deuxièmes parties des structures d'aspiration (6) étant formées à partir des régions fortement dopées (62) du premier type de conductibilité (n) et en ce qu'une couche métallique est prévue comme deuxième électrode principale (7), qui est raccordée de façon conductrice électriquement à au moins une région émettrice (4) du deuxième type de conductibilité (P) et à au moins une deuxième partie (6) d'une structure d'aspiration.

9. Procédé de fabrication d'un composant semi-conducteur de puissance selon la revendication 1, caractérisé en ce que l'épaisse couche faiblement dopée (51) du deuxième type de conductibilité est conductrice du type P et en ce que la couche fortement dopée (61) du premier type de conductibilité (n) est formée à l'aide d'arsenic ou d'antimoine en tant qu'agent de dopage.
